# EUROPEAN PATENT APPLICATION

(11) **EP 4 712 327 A1**
(43) Date of publication of application: **18.03.2026**
(21) Application number: 24863054.3
(22) Date of filing: 09.08.2024
(51) Int. Cl.: H02M 1/12, H02P 29/50, H01F 17/06, D06F 58/00

(54) **ELECTRONIC DEVICE AND CONTROL METHOD THEREOF**

(30) Priority: 08.09.2023 KR 20230119829
(71) Applicant: Samsung Electronics Co., Ltd., Suwon-si, Gyeonggi-do 16677 (KR)
(72) Inventor: MIN, Sail, Suwon-si Gyeonggi-do 16677 (KR); CHOI, Jihwan, Suwon-si Gyeonggi-do 16677 (KR); KIM, Sooam, Suwon-si Gyeonggi-do 16677 (KR)
(74) Representative: Gulde & Partner
(86) International application number: PCT/KR2024/011933
(87) International publication number: WO 2025/053472

(57) **Abstract**

This dryer comprises: a drum for accommodating an object to be dried; a hot air supply device for supplying hot air into the drum; a motor used to rotate the drum; a power supply device for supplying power to the motor; and
at least one processor for controlling the motor. The power supply device comprises: a power terminal unit for receiving AC power including a ground wire through a first input terminal and a second input terminal; an **EMI** filter for removing noise included in the AC power; and a ground terminal including the ground wire connected to the power supply device. The **EMI** filter comprises: an X capacitor unit including a first capacitor; a first common mode filter including a first core, a first inductor wound around the first core, and a second inductor wound around the first core; a Y capacitor unit including a second capacitor and a third capacitor connected in series; and a second common mode filter including a second core, a third inductor wound around the second core, a fourth capacitor connected in parallel to the third inductor, a fourth inductor wound around the second core, and a fifth capacitor connected in parallel to the fourth inductor.

## Description

### [Technical Field]

The present disclosure relates to an electronic apparatus and a control method thereof, and more particularly, to an electronic apparatus including a filter for removing noise and a control method thereof.

### [Background Art]

An electro-magnetic interference (EMI) filter may be used to remove a noise signal generated in a home appliance.

EMI may indicate that an electromagnetic wave radiated or conducted interferes with a function of an electronic circuit. EMI may indicate noise. Noise may indicate an unnecessary electromagnetic wave.

The EMI filter may filter a noise signal generated while power is supplied to the home appliance. By using the EMI filter, stable power may be supplied to the home appliance. The EMI filter may be described as a noise filter.

The EMI filter may block, absorb, or bypass noise occurring in the home appliance.

An electrical noise signal may have various forms. The noise signal may include at least one of a common mode current or a differential mode current. Various flows may exist even in the common mode current.

The EMI filter may be designed in response to a conducted emission (CE). The EMI filter may remove noise corresponding to a predetermined flow in design. The EMI filter may not remove noise corresponding to disturbance power (DP).

A common mode filter may be used to filter the common mode current, and a differential mode filter may be used to filter the differential mode current.

As an impedance magnitude in the common mode filter increases, an interference-current suppression performance at a specific frequency may proportionally increase. To increase the impedance magnitude, inductance may be increased by increasing a permeability of a magnetic material or increasing the number of turns of windings.

However, when the inductance increases, parasitic floating capacitance (e.g., parasitic resistance or parasitic capacitance) between the windings may change. When the parasitic floating capacitance changes, a self-resonant frequency of the filter may decrease, and accordingly, impedance may increase only in a band lower than the self-resonant frequency and decrease in a band higher than the self-resonant frequency.

When it is difficult to increase the permeability of the magnetic material (e.g., inductor replacement), it may be difficult to increase the impedance.

When it is difficult to increase the number of turns of windings (e.g., lack of core size), it may be difficult to increase the impedance.

When it is difficult to increase a size of the magnetic material, it may be difficult to increase the impedance.

When a magnetic material used for the common mode filter is changed, difficulty in component standardization or common use may occur.

### [Disclosure of Invention]

### [Solution to Problem]

The present disclosure provides an electronic apparatus for changing impedance by disposing an additional capacitor in a common mode filter included in an electro-magnetic interference (EMI) filter, and a control method thereof.

According to an embodiment of the present disclosure, provided is a dryer including: a drum configured to accommodate an object to be dried; a hot air supply device configured to supply hot air into the drum; a motor configured to rotate the drum; a power supply device configured to supply power to the motor; and at least one processor configured to control the motor, wherein the power supply device includes: a power terminal unit configured to receive alternating current (AC) power including a ground wire through a first input terminal and a second input terminal; an electro-magnetic interference (EMI) filter configured to remove noise included in the AC power; and a ground terminal including the ground wire connected to the power supply device, and the **EMI** filter includes: an X capacitor unit including a first capacitor; a first common mode filter including a first core, a first inductor wound around the first core, and a second inductor wound around the first core; a Y capacitor unit including a second capacitor and a third capacitor connected in series; and a second common mode filter including a second core, a third inductor wound around the second core, a fourth capacitor connected in parallel to the third inductor, a fourth inductor wound around the second core, and a fifth capacitor connected in parallel to the fourth inductor.

The at least one processor may be configured to control the hot air supply device by supplying, to the motor, the AC power from which noise is removed through the electro-magnetic interference (EMI) filter.

The power supply device may include a first output terminal and a second output terminal connected to the second common mode filter.

One end of the first inductor may be commonly connected to one end of the first capacitor and the first input terminal, and the other end of the first inductor may be commonly connected to one end of the second capacitor, one end of the fourth capacitor, and one end of the third inductor.

One end of the second inductor may be commonly connected to the other end of the first capacitor and the second input terminal, and the other end of the second inductor may be commonly connected to the other end of the third capacitor, one end of the fifth capacitor, and one end of the fourth inductor.

The other end of the third inductor may be connected to the other end of the fourth capacitor and the first output terminal, and the other end of the fourth inductor may be connected to the other end of the fifth capacitor and the second output terminal.

The first inductor and the second inductor may be connected in series, and the third inductor and the fourth inductor may be connected in series.

The first core may be made of a magnetic material, the first inductor and the second inductor may be wound around the first core in the same direction, the second core may be made of a magnetic material, and the third inductor and the fourth inductor may be wound around the second core in the same direction.

The ground terminal may be commonly connected to the other end of the second capacitor and one end of the third capacitor.

The motor may be a brushless direct current (BLDC) motor, and the motor may receive power passing through the EMI filter.

The dryer may further include a board on which the power terminal unit and the EMI filter are disposed.

The X capacitor unit may be a first X capacitor unit, the EMI filter may further include a second X capacitor unit including a sixth capacitor, and the second X capacitor unit may be connected in parallel to the first X capacitor unit, the first common mode filter, the Y capacitor unit, and the second common mode filter.

One end of the sixth capacitor may be commonly connected to the other end of the first inductor, one end of the second capacitor, one end of the fourth capacitor, and one end of the third inductor, and the other end of the sixth capacitor may be commonly connected to the other end of the second inductor, the other end of the third capacitor, one end of the fifth capacitor, and one end of the fourth inductor.

The **EMI** filter may include a differential mode filter including a fifth inductor and a sixth inductor, and the differential mode filter may be connected in parallel to the first X capacitor unit, the first common mode filter, the Y capacitor unit, and the second common mode filter.

One end of the fifth inductor may be commonly connected to the other end of the fourth capacitor and the other end of the third inductor, and the other end of the fifth inductor may be connected to the first output terminal.

One end of the sixth inductor may be commonly connected to the other end of the fifth capacitor and the other end of the fourth inductor, and the other end of the sixth inductor may be connected to the second output terminal.

According to an embodiment of the present disclosure, provided is a home appliance including: a motor; a power supply device configured to supply power to the motor; and at least one processor configured to control the motor, wherein the power supply device includes: a power terminal unit configured to receive alternating current (AC) power including a ground wire through a first input terminal and a second input terminal; an electro-magnetic interference (EMI) filter configured to remove noise included in the AC power; and a ground terminal including the ground wire connected to the power supply device, and the **EMI** filter includes: an X capacitor unit including a first capacitor; a first common mode filter including a first core, a first inductor wound around the first core, and a second inductor wound around the first core; a Y capacitor unit including a second capacitor and a third capacitor connected in series; and a second common mode filter including a second core, a third inductor wound around the second core, a fourth capacitor connected in parallel to the third inductor, a fourth inductor wound around the second core, and a fifth capacitor connected in parallel to the fourth inductor.

The home appliance may be implemented as one of a dryer or an air conditioner.

The power supply device may include a first output terminal and a second output terminal connected to the second common mode filter.

One end of the first inductor may be commonly connected to one end of the first capacitor and the first input terminal, and the other end of the first inductor may be commonly connected to one end of the second capacitor, one end of the fourth capacitor, and one end of the third inductor.

One end of the second inductor may be commonly connected to the other end of the first capacitor and the second input terminal, and the other end of the second inductor may be commonly connected to the other end of the third capacitor, one end of the fifth capacitor, and one end of the fourth inductor.

### [Brief Description of Drawings]

FIG. 1 is a block diagram illustrating an electronic apparatus according to an embodiment.
FIG. 2 is a diagram illustrating an electronic apparatus according to an embodiment.
FIG. 3 is a block diagram illustrating the electronic apparatus according to an embodiment.
FIG. 4 is a diagram illustrating a power supply device according to an embodiment.
FIG. 5 is a diagram illustrating the power supply device according to an embodiment.
FIG. 6 is a diagram illustrating the power supply device according to an embodiment.
FIG. 7 is a diagram illustrating the power supply device according to an embodiment.
FIG. 8 is a diagram illustrating the power supply device according to an embodiment.
FIG. 9 is a diagram illustrating the power supply device according to an embodiment.
FIG. 10 is a diagram illustrating the power supply device according to an embodiment.
FIG. 11 is a diagram illustrating the power supply device according to an embodiment.
FIG. 12 is a diagram illustrating the power supply device according to an embodiment.
FIG. 13 is a diagram illustrating the power supply device according to an embodiment.
FIG. 14 is a diagram illustrating a change in impedance according to an inductor type.
FIG. 15 is a diagram illustrating an operation of determining a capacitance of an additionally disposed capacitor for impedance increase.
FIG. 16 is a diagram illustrating a change in impedance caused by the additionally disposed capacitor.
FIG. 17 is a diagram illustrating a second common mode filter 142.
FIG. 18 is a diagram illustrating a first common mode filter 130.
FIG. 19 is a diagram illustrating an equipment under test (EUT) and a line impedance stabilization network (LISN).
FIG. 20 is a diagram illustrating the line impedance stabilization network.
FIG. 21 is a diagram illustrating an interference current flowing between the equipment under test and the line impedance stabilization network.
FIG. 22 is a diagram illustrating an electro-magnetic interference (EMI) filter and the interference current according to an embodiment.
FIG. 23 is a diagram illustrating the **EMI** filter and the interference current according to an embodiment.

### [Mode for Invention]

Hereinafter, the embodiments of the present disclosure are described in detail with reference to the accompanying drawings.

General terms that are currently widely used are selected as terms used in embodiments of the present disclosure in consideration of their functions in the present disclosure, and may be changed based on the intention of those skilled in the art or a judicial precedent, the emergence of a new technique, or the like. In addition, in a specific case, terms arbitrarily chosen by an applicant may exist. In this case, the meanings of such terms are mentioned in detail in corresponding descriptions of the present disclosure. Therefore, the terms used in the present disclosure need to be defined on the basis of the meanings of the terms and the contents throughout the present disclosure rather than simple names of the terms.

**In** the present disclosure, the expression such as "have", "may have", "include", or "may include", indicates the presence of a corresponding feature (e.g., a numerical value, a function, an operation, or a component such as a part), and does not exclude the presence of an additional feature.

An expression such as "at least one of A or/and B" may indicate either "A or B", or "both of A and B."

Expressions such as "first" and "second", used in the present disclosure may indicate various components regardless of the sequence or importance of the components. The expression is used only to distinguish one component from another component, and does not limit the corresponding component.

If any component (e.g., a first component) is mentioned to be "(operatively or communicatively) coupled with/to" or "connected to" another component (e.g., a second component), it should be understood that the any component is directly coupled to another component or may be coupled to another component through yet another component (e.g., a third component).

A term of a singular number may include its plural number unless explicitly indicated otherwise in the context. It should be understood that in this application, terms such as "include" or "have" indicate that the presence of the features, numbers, steps, operations, components, parts, or combinations thereof, which are described in the specification, and do not preclude the presence or addition of one or more other features, numbers, steps, operations, components, parts, or combinations thereof.

In the present disclosure, a "module" or a "part" may perform at least one function or operation, and be implemented by hardware or software or be implemented by a combination of hardware and software. In addition, a plurality of "modules" or a plurality of "parts" may be integrated in at least one module and be implemented by at least one processor (not shown) except for a "module" or a "part" that needs to be implemented by specific hardware.

In the present disclosure, a term such as a "user" may refer to a person who uses an electronic apparatus or an apparatus (e.g., an artificial intelligence electronic apparatus) which uses an electronic apparatus.

Hereinafter, an embodiment of the present disclosure is described in more detail with reference to the accompanying drawings.

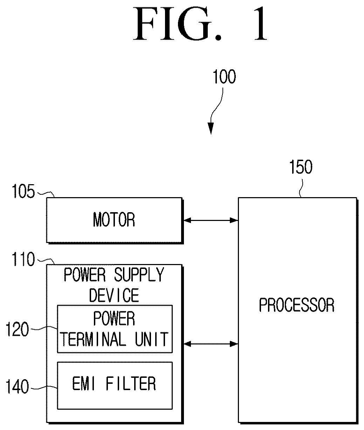

FIG. 1 is a block diagram illustrating an electronic apparatus according to an embodiment.

Referring to FIG. 1, an electronic apparatus 100 may include at least one of a motor 105, a power supply device 110 for supplying power to the motor 105, or at least one processor 150 for controlling the motor 105.

The motor 105 may generate a force for driving the electronic apparatus 100. The motor 105 may generate noise.

An electro-magnetic interference (EMI) filter 140 may absorb or remove noise.

At least one processor 150 may perform overall operations of the electronic apparatus 100.

The power supply device 110 may include the EMI filter 140 for removing noise included in external power (e.g., alternating current (AC) power).

Noise may occur during external power supply. Noise may be unnecessary electromagnetic waves occurring during the external power supply. Noise may be described as a noise signal.

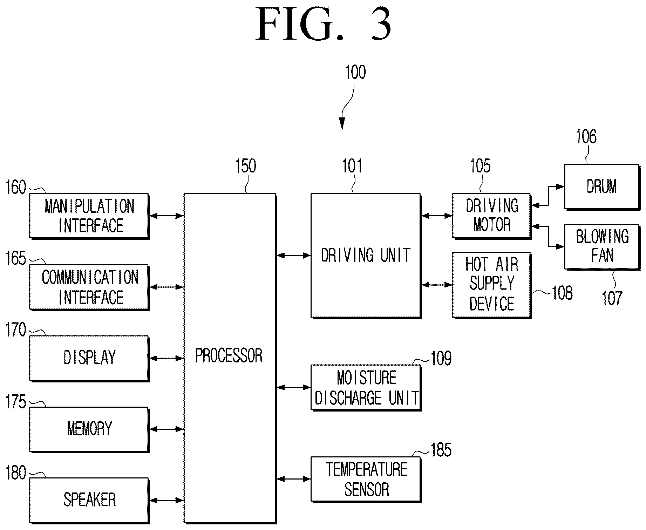

The electronic apparatus 100 may include various home appliances driven by the motor 105. For example, the electronic apparatus 100 may be implemented as a dryer. A detailed configuration of the dryer is described with reference to FIG. 3.

The power supply device 110 may include at least one of a power terminal unit 120 for receiving The AC power including a ground wire through a first input terminal Li and a second input terminal Ni, the EMI filter 140 for removing noise included in the AC power, or a ground terminal of the power supply device 110.

The EMI filter 140 may include at least one of an X capacitor unit 141, a first common mode filter 142, a Y capacitor unit 143, or a second common mode filter 144.

The X capacitor unit 141 may include a first capacitor C1.

The first common mode filter 142 may include a first core, a first inductor L4 wound around the first core, and a second inductor L5 wound around the first core.

The Y capacitor unit 143 may include a second capacitor C2 and a third capacitor C3 connected in series.

The second common mode filter 144 may include a second core, a third inductor L6 wound around the second core, a fourth capacitor C4 connected in parallel to the third inductor L6, a fourth inductor L7 wound around the second core, and a fifth capacitor C5 connected in parallel to the fourth inductor L7.

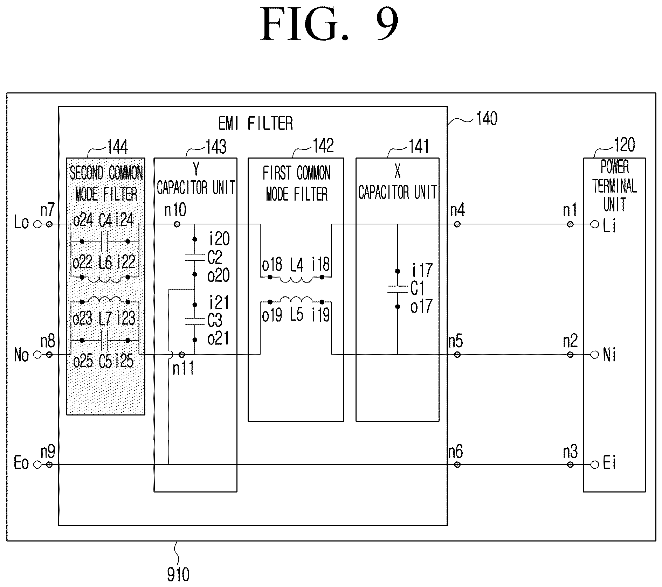

The first inductor L4 may correspond to a fourth inductor L4 in FIG. 9. The second inductor L5 may correspond to a fifth inductor L5 in FIG. 9. The third inductor L6 may correspond to a sixth inductor L6 in FIG. 9. The fourth inductor L7 may correspond to a seventh inductor L7. An ordinal number denoting an inductor may be changed depending on a description order.

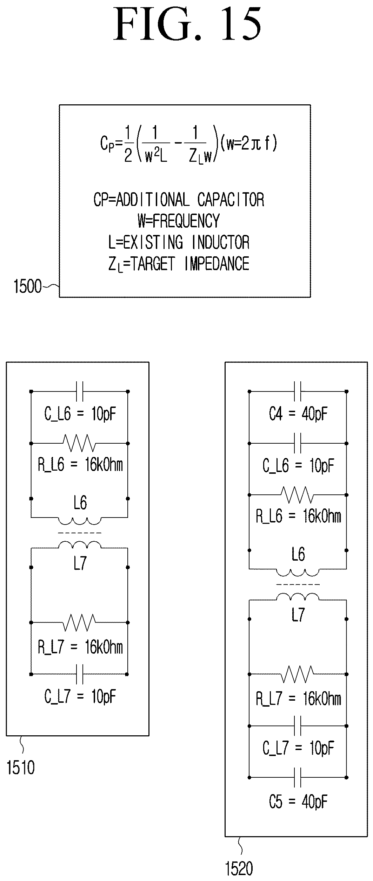

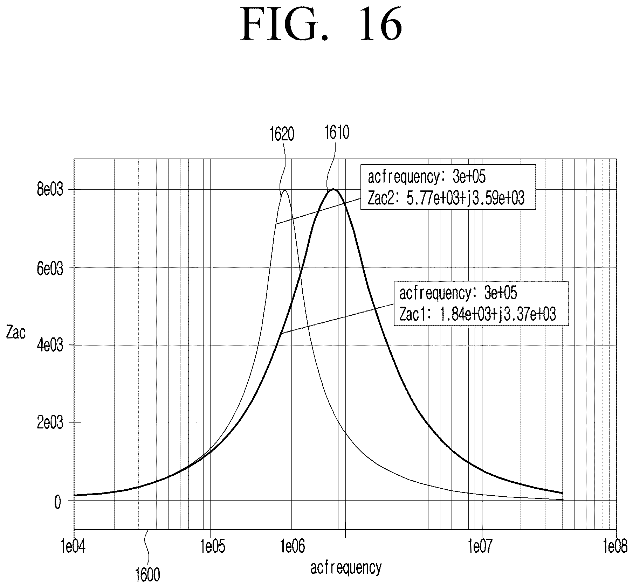

Impedance of the second common mode filter 144 may be increased through the fourth capacitor C4 connected in parallel to the third inductor L6 and the fifth capacitor C5 connected in parallel to the fourth inductor L7. An effect thereof is described with reference to FIGS. 15 and 16. The fourth capacitor C4 and the fifth capacitor C5 may be described as target capacitors or additional capacitors.

A detailed description of the EMI filter 140 including the X capacitor unit 141, the first common mode filter 142, the Y capacitor unit 143, and the second common mode filter 144 is provided with reference to FIG. 9.

External power (e.g., AC power) may be single-phase AC power.

A common mode filter may be referred to as a common mode choke, a common mode coil, a common mode choke coil, a noise filter, an inductor unit, or the like.

The first common mode filter 142 and the second common mode filter 144 may remove a common mode current, which is noise occurring in power.

The dryer may further include a drum 106 and a hot air supply device 108 for supplying hot air into the drum 106.

At least one processor 150 may control the hot air supply device 108 by supplying, to the motor 105, The AC power from which noise is removed through the EMI filter 140.

The power supply device 110 may include a first output terminal Lo and a second output terminal No connected to the second common mode filter 144.

One end i18 of the first inductor L4 may be commonly connected to one end i17 of the first capacitor C1 and the first input terminal Li.

The other end o18 of the first inductor L4 may be commonly connected to one end i20 of the second capacitor C2, one end i24 of the fourth capacitor C4, and one end i22 of the third inductor L6.

One end i19 of the second inductor L5 may be commonly connected to the other end o17 of the first capacitor C1 and the second input terminal Ni.

The other end o19 of the second inductor L5 may be commonly connected to the other end o21 of the third capacitor C3, one end i25 of the fifth capacitor C5, and one end i23 of the fourth inductor L7.

The other end o22 of the third inductor L6 may be connected to the other end o24 of the fourth capacitor C4 and the first output terminal Lo.

The other end o23 of the fourth inductor L7 may be connected to the other end o25 of the fifth capacitor C5 and the second output terminal No.

The first inductor L4 and the second inductor L5 may be connected in series. The third inductor L6 and the fourth inductor L7 may be connected in series.

The first core may be made of a magnetic material, and the first inductor L4 and the second inductor L5 may be wound around the first core in the same direction.

The second core may be made of a magnetic material, and the third inductor L6 and the fourth inductor L7 may be wound around the second core in the same direction.

A ground terminal Eo=Ei may be commonly connected to the other end o20 of the second capacitor C2 and one end i21 of the third capacitor C3.

The motor 105 may be a brushless direct current (BLDC) motor 105, and may receive power passing through the EMI filter 140.

The dryer may further include a board on which the power terminal unit 120 and the EMI filter 140 are disposed.

The X capacitor unit 141 may be a first X capacitor unit 141, and the EMI filter 140 may further include a second X capacitor unit 145 including a sixth capacitor C6.

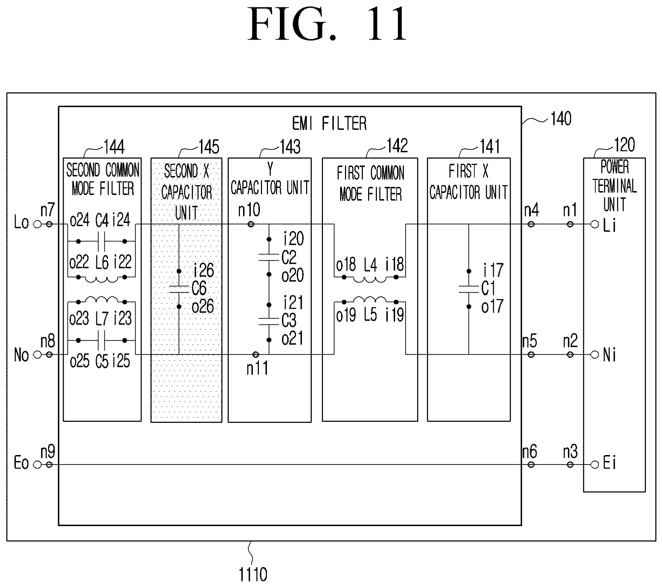

A detailed description of the second X capacitor unit 145 is provided with reference to FIG. 11.

The second X capacitor unit 145 may be connected in parallel to the first X capacitor unit 141, the first common mode filter 142, the Y capacitor unit 143, and the second common mode filter 144.

One end i26 of the sixth capacitor C6 may be commonly connected to the other end o18 of the first inductor L4, one end i20 of the second capacitor C2, one end i24 of the fourth capacitor C4, and one end i22 of the third inductor L6.

The other end o26 of the sixth capacitor C6 may be commonly connected to the other end o19 of the second inductor L5, the other end o21 of the third capacitor C3, one end i25 of the fifth capacitor C5, and one end i23 of the fourth inductor L7.

The EMI filter 140 may include a differential mode filter 146 including a fifth inductor L8 and a sixth inductor L9.

The differential mode filter 146 may be connected in parallel to the first X capacitor unit 141, the first common mode filter 142, the Y capacitor unit 143, and the second common mode filter 144.

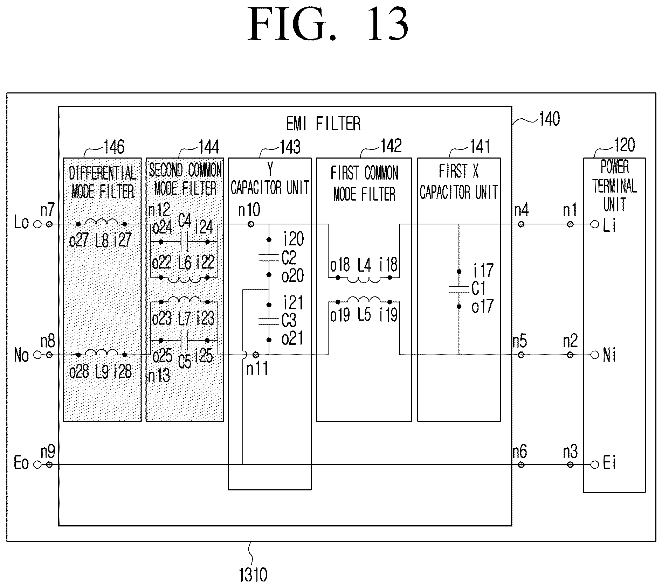

A detailed description of the differential mode filter 146 is provided with reference to FIG. 13.

One end i27 of the fifth inductor L8 may be commonly connected to the other end o24 of the fourth capacitor C4 and the other end o22 of the third inductor L6.

The other end o27 of the fifth inductor L8 may be connected to the first output terminal Lo.

One end i28 of the sixth inductor L9 may be commonly connected to the other end o25 of the fifth capacitor C5 and the other end o23 of the fourth inductor L7.

The other end o28 of the sixth inductor L9 may be connected to the second output terminal No.

The home appliance may include at least one of the motor 105, the power supply device 110 for supplying power to the motor 105, or at least one processor 150 for controlling the motor 105.

The power supply device 110 may include at least one of the power terminal unit 120 for receiving the AC power including the ground wire through the first input terminal Li and the second input terminal Ni, the EMI filter 140 for removing noise included in the AC power, or the ground terminal of the power supply device 110. The ground terminal may include the ground wire.

The home appliance may be implemented as one of a dryer or an air conditioner.

A configuration of the power supply device 110 or that of the EMI filter 140 included in the power supply device 110 may correspond to a configuration of the dryer described above. A redundant description thereof is omitted.

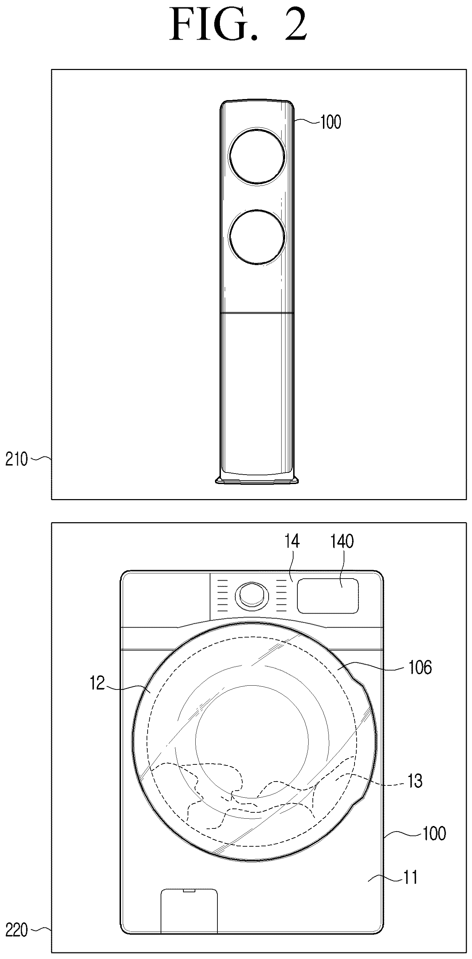

FIG. 2 is a diagram illustrating an electronic apparatus 100 according to an embodiment.

Referring to Embodiment 210 in FIG. 2, the electronic apparatus 100 may be implemented as an air conditioner (e.g., air conditioning device or an air conditioning control device). The electronic apparatus 100 may be the air conditioning control device including a cooling function or a heating function, and the electronic apparatus 100 may include an electro-magnetic interference (EMI) filter 140. An embodiment related to the air conditioner is described with reference to FIG. 3.

Referring to Embodiment 220 in FIG. 2, the electronic apparatus 100 may be implemented as a dryer or a washing machine. The electronic apparatus 100 may include the EMI filter 140.

The electronic apparatus 100 may include a cabinet 11, a door 12, a drum 106, a manipulation panel 14, and a display 170.

Referring to Diagram 10 illustrating the electronic apparatus 100, the electronic apparatus 100 may be a device for drying an object 13 to be dried after washing is completed. The object 13 to be dried may be clothing, bedding, towels, or the like, and is not limited thereto. The object 13 to be dried may be expressed as the object to be dried.

The electronic apparatus 100 may include an air circulation device (not illustrated) for circulating air in the drum 106 and a hot air supply device (not illustrated) for heating medium-temperature and high-humidity air discharged from the drum 106 into high-temperature and low-humidity air. For example, the object 13 to be dried that is damp after washing may be dried in the drum 106 of the electronic apparatus 100 based on operations of the air circulation device and the hot air supply device.

To effectively dry the object to be dried, the drum 106 may continuously rotate to allow high-temperature and low-humidity air uniformly to come into contact with the object to be dried.

The cabinet 11 may include an inlet disposed in a front surface, through which the object 13 to be dried may be inserted and removed from the cabinet 11. The door 12 may be hinge-coupled to the front surface of the cabinet 11 to open or close the inlet of the cabinet 11.

The manipulation panel 14 for controlling the electronic apparatus 100 may be disposed on an upper front portion of the cabinet 11. The manipulation panel 14 may include the display 170 for displaying a state of the electronic apparatus 100. A user may operate the manipulation panel 14 to operate the electronic apparatus 100. The manipulation panel 14 may correspond to a manipulation interface 160. The manipulation panel 14 may be implemented as a circular dial or a touch panel.

The drum 106 may be rotatably installed inside the cabinet 11, and one end of the drum 106 may be installed to communicate with the inlet of the cabinet 11.

A sensing device according to an embodiment of the present disclosure may be introduced into the drum 106 through the inlet of the electronic apparatus 100.

Although FIG. 2 illustrates that the electronic apparatus 100 is implemented as an air conditioner, a dryer, or a washing machine, the electronic apparatus 100 may be various electronic devices in which noise occurs.

FIG. 3 is a block diagram illustrating a detailed configuration of a dryer according to various embodiments of the present disclosure.

Referring to FIG. 3, the electronic apparatus 100 may include a user interface 160, a communication interface 165, a driving unit 101, a driving motor 105, a drum 106, a blowing fan 107, a hot air supply device 108, a moisture discharge unit 109, at least one processor 150, a display 170, a memory 175, a speaker 180, and a temperature sensor 185.

The manipulation interface 160 may be implemented as a device such as a button, a touch pad, a mouse, or a keyboard, or may be implemented as a touch screen capable of performing both a display function and a manipulation input function as described above. The button may be implemented as any of various types of buttons such as a mechanical button, a touch pad, or a wheel disposed on any region such as a front surface, a side surface, or a rear surface of an exterior of the electronic apparatus 100.

Redundant descriptions of the same operations as those of the communication interface 165 and at least one processor 150 described above are omitted.

The driving unit 101 may drive the driving motor 105 based on a driving control signal generated by at least one processor 150.

The driving motor 105 may receive power to generate a driving force, and the driving motor 105 may transmit the generated driving force to the drum 106 and the blowing fan 107.

The drum 106 may indicate a drying tub for accommodating the object to be dried. The drum 106 may be rotated by the driving force generated by the driving motor 105.

The blowing fan 107 may indicate a fan for circulating high-temperature air supplied to the drum of the electronic apparatus 100. **In** detail, the blowing fan 107 may receive a driving control signal generated by at least one processor 150 and may rotate to circulate air in the drum to which a heat source is supplied.

The driving unit 101 may receive the driving control signal generated by at least one processor 150 and may drive the hot air supply device 108 to supply the heat source to the drum.

The hot air supply device 108 may supply the heat source to the drum 106.

The hot air supply device 108 may be implemented by using a gas-type heat source supply method or an electric-type heat source supply method. The gas type may indicate a method of heating air by using gas. The electric type may indicate a method of heating air by using electricity. The electric type may be a method using at least one of a hot air supply device or a heat pump. The hot air supply device may use a method of supplying a heat source by using a heating wire. The heat pump may use a method of supplying a heat source by using a refrigerant. The heat pump may include an evaporator, a compressor, and a condenser. In detail, the evaporator may evaporate a refrigerant in a liquid state into a gaseous state. In addition, the refrigerant in the gaseous state may be transferred to the compressor. The compressor may compress the refrigerant into a high-temperature and high-pressure state. In addition, the compressed refrigerant may be transferred to the condenser. The condenser may perform a heat exchange operation on the compressed refrigerant to extract heat therefrom, and may heat and discharge high-temperature air by using extracted heat. The discharged high-temperature air may be supplied to the drum 106 of the electronic apparatus 100. The refrigerant, from which heat is extracted by the condenser, may be transferred to the evaporator and circulated.

The moisture discharge unit 109 may discharge moisture inside the electronic apparatus 100. The electronic apparatus 100 may use a vent type (a hot air exhaust method) or a condensing type (a hot air dehumidification method) based on a moisture discharge method. The vent type may indicate a method of discharging moisture and dust to the outside of the electronic apparatus 100. The condensing type may indicate a method of filtering dust by using a filter and converting moisture into condensate by passing the moisture through a condenser (or a heat exchanger). The condensate may be discharged to the outside of the electronic apparatus 100 or stored in an internal container of the electronic apparatus 100.

The display 170 may be implemented as various types of displays such as a liquid crystal display (LCD), an organic light-emitting diode (OLED) display, or a plasma display panel (PDP). The display 170 may further include a driving circuit, a backlight unit, and the like, which may be implemented as an amorphous silicon thin-film transistor (a-si TFT), a low temperature poly-silicon thin-film transistor (LTPS TFT), or an organic thin-film transistor (OTFT). The display 170 may be implemented as a touch screen coupled to a touch sensor, a flexible display, or a three-dimensional (3D) display.

In an embodiment according to the present disclosure, the display 170 may include not only a display panel for outputting an image but also a bezel for housing the display panel. In particular, in an embodiment according to the present disclosure, the bezel may include a touch sensor (not illustrated) for detecting user interaction.

The memory 175 may be implemented as an internal memory such as a read only memory (ROM) (e.g., an electrically erasable and programmable ROM (EEPROM)) or a random access memory (RAM) included in at least one processor 150, or may be implemented as a memory separate from at least one processor 150. In this case, the memory 175 may be implemented as a memory embedded in the electronic apparatus 100 based on a data storage purpose, or as a memory detachable from the electronic apparatus 100. For example, data for driving the electronic apparatus 100 may be stored in the memory embedded in the electronic apparatus 100, and data for an extension function of the electronic apparatus 100 may be stored in a memory detachable from the electronic apparatus 100.

The memory embedded in the electronic apparatus 100 may be implemented as at least one of a volatile memory (e.g., a dynamic random access memory (DRAM), a static RAM (SRAM), or a synchronous dynamic RAM (SDRAM)) or a non-volatile memory (e.g., an one time programmable ROM (OTPROM), a programmable ROM (PROM), an erasable and programmable ROM (EPROM), an electrically erasable and programmable ROM (EEPROM), a mask ROM, a flash memory (e.g., a NAND flash or a NOR flash), a hard drive, or a solid-state drive (SSD)), and the memory detachable from the electronic apparatus 100 may be implemented as a memory card (e.g., a compact flash (CF), a secure digital (SD), a micro secure digital (Micro-SD), a mini secure digital (Mini-SD), an extreme digital (xD), or a multi-media card (MMC)) or as an external memory (e.g., a USB memory) connectable to a universal serial bus (USB) port.

The speaker 180 may be a component for outputting various audio data processed by an input/output interface as well as various notification sounds or voice messages.

The temperature sensor 185 may sense an internal temperature of the electronic apparatus 100. The temperature sensor 185 may include at least one of a first temperature sensor for sensing an air temperature in the drum 106 inside the electronic apparatus 100 or a second temperature sensor for sensing a refrigerant temperature inside the electronic apparatus 100. Temperature data sensed by the temperature sensor 185 may be transferred to at least one processor 150, and at least one processor 150 may control an operation of the electronic apparatus 100 based on the sensed temperature data.

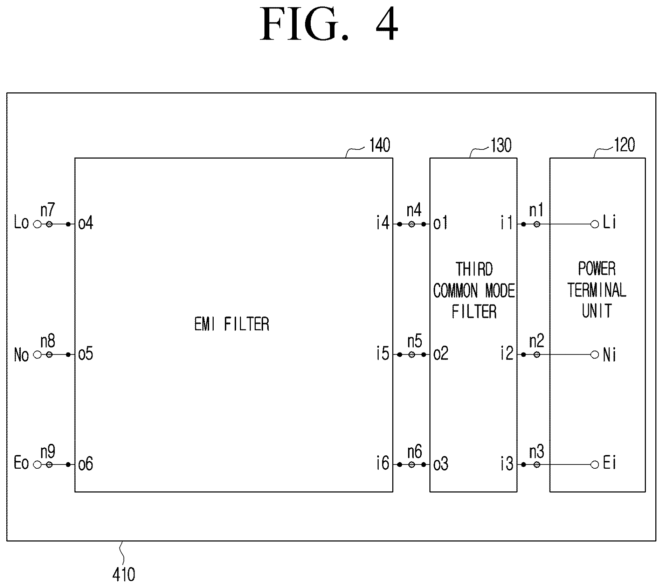

FIG. 4 is a diagram illustrating a power supply device 110 according to an embodiment.

Referring to Embodiment 410 in FIG. 4, the power supply device 110 may include at least one of a power terminal unit 120, a third common mode filter 130, or an electro-magnetic interference (EMI) filter 140.

The power supply device 110 may include at least one of the first input terminal Li, the second input terminal Ni, a third input terminal Ei, the first output terminal Lo, the second output terminal No, or a third output terminal Eo.

The first input terminal Li, second input terminal Ni, and third input terminal Ei of the power supply device 110 may be included in an input terminal unit of the power supply device 110.

The first output terminal Lo, second output terminal No, and third output terminal Eo of the power supply device 110 may be included in an output terminal unit of the power supply device 110. The third output terminal Eo may be connected to the ground wire (or the ground terminal).

The power terminal unit 120 may include at least one of the first terminal Li, the second terminal Ni, or the third terminal Ei.

The first terminal Li of the power terminal unit 120 may be referred to as the first input terminal of the power supply device 110.

The second terminal Ni of the power terminal unit 120 may be referred to as the second input terminal of the power supply device 110.

The third terminal Ei of the power terminal unit 120 may be referred to as the third input terminal of the power supply device 110.

The power terminal unit 120 may be referred to as the input terminal unit.

The third common mode filter 130 may include at least one of a first input terminal i1, a second input terminal i2, a third input terminal i3, a first output terminal o1, a second output terminal o2, or a third output terminal o3.

The EMI filter 140 may include at least one of a first input terminal i4, a second input terminal i5, a third input terminal i6, a first output terminal o4, a second output terminal o5, or a third output terminal o6.

The first input terminal i1 of the third common mode filter 130 may be connected to the first terminal Li of the power terminal unit 120 through a node n1.

The second input terminal i2 of the third common mode filter 130 may be connected to the second terminal Ni of the power terminal unit 120 through a node n2.

The third input terminal i3 of the third common mode filter 130 may be connected to the third terminal Ei of the power terminal unit 120 through a node n3.

The first output terminal o1 of the third common mode filter 130 may be connected to the first input terminal i4 of the EMI filter 140 through a node n4.

The second output terminal o2 of the third common mode filter 130 may be connected to the second input terminal i5 of the EMI filter 140 through a node n5.

The third output terminal o3 of the third common mode filter 130 may be connected to the third input terminal i6 of the EMI filter 140 through a node n6.

The first output terminal o4 of the EMI filter 140 may be connected to the first output terminal Lo of the power supply device 110 through a node n7.

The second output terminal o5 of the EMI filter 140 may be connected to the second output terminal No of the power supply device 110 through a node n8.

The third output terminal o6 of the EMI filter 140 may be connected to the third output terminal Eo of the power supply device 110 through a node n9.

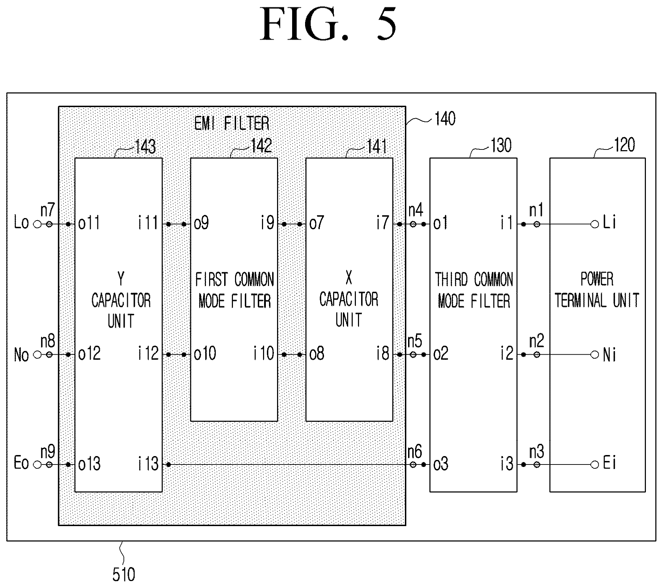

FIG. 5 is a diagram illustrating the power supply device 110 according to an embodiment.

Referring to Embodiment 510 in FIG. 5, the power supply device 110 may include at least one of the power terminal unit 120, the third common mode filter 130, or the EMI filter 140. The power supply device 110 in FIG. 5 may correspond to the power supply device 110 in FIG. 4. A redundant description thereof is omitted.

The EMI filter 140 may include at least one of the X capacitor unit 141, the first common mode filter 142, or the Y capacitor unit 143.

The X capacitor unit 141 may include at least one of a first input terminal i7, a second input terminal i8, a first output terminal o7, or a second output terminal o8.

The first common mode filter 142 may include at least one of a first input terminal i9, a second input terminal i10, a first output terminal o9, or a second output terminal o10.

The Y capacitor unit 143 may include at least one of a first input terminal i11, a second input terminal i12, a third input terminal i13, a first output terminal o11, a second output terminal o12, or a third output terminal o13.

The first output terminal o1 of the third common mode filter 130 may be connected to the first input terminal i7 of the X capacitor unit 141 through the node n4.

The second output terminal o2 of the third common mode filter 130 may be connected to the second input terminal i8 of the X capacitor unit 141 through the node n4.

The third output terminal o3 of the third common mode filter 130 may be connected to the third input terminal i13 of the Y capacitor unit 143 through the node n6.

The first output terminal o7 of the X capacitor unit 141 may be connected to the first input terminal i9 of the first common mode filter 142.

The second output terminal o8 of the X capacitor unit 141 may be connected to the second input terminal i10 of the first common mode filter 142.

The first output terminal o9 of the first common mode filter 142 may be connected to the first input terminal i11 of the Y capacitor unit 143.

The second output terminal o10 of the first common mode filter 142 may be connected to the first input terminal i12 of the Y capacitor unit 143.

The first output terminal o11 of the Y capacitor unit 143 may be connected to the first output terminal Lo of the power supply device 110 through the node n7.

The second output terminal o12 of the Y capacitor unit 143 may be connected to the second output terminal No of the power supply device 110 through the node n8.

The third output terminal o13 of the Y capacitor unit 143 may be connected to the third output terminal Eo of the power supply device 110 through the node n9.

The first input terminal i4 of the EMI filter 140 in FIG. 4 may be connected to the first input terminal i7 of the X capacitor unit 141 through the node n4.

The second input terminal i5 of the EMI filter 140 in FIG. 4 may be connected to the second input terminal i8 of the X capacitor unit 141 through the node n5.

The third input terminal i6 of the EMI filter 140 in FIG. 4 may be connected to the third input terminal i13 of the Y capacitor unit 143 through the node n6.

The first output terminal o4 of the EMI filter 140 in FIG. 4 may be connected to the first output terminal o11 of the Y capacitor unit 143 through the node n7.

The second output terminal o5 of the EMI filter 140 in FIG. 4 may be connected to the second output terminal o12 of the Y capacitor unit 143 through the node n8.

The third output terminal o6 of the EMI filter 140 in FIG. 4 may be connected to the third output terminal o13 of the Y capacitor unit 143 through the node n9.

An arrangement of the X capacitor unit 141, the first common mode filter 142, and the Y capacitor unit 143 included in the EMI filter 140 may differ. For example, the X capacitor unit 141, the first common mode filter 142, and the Y capacitor unit 143 may be implemented to have a structure different from the arrangement structure disclosed in FIG. 5.

The EMI filter 140 in FIG. 5 is described as including only one X capacitor unit 141, one first common mode filter 142, and one Y capacitor unit 143. According to an implementation example, the EMI filter 140 may include at least one X capacitor unit 141, at least one first common mode filter 142, or at least one Y capacitor unit 143.

For example, the EMI filter 140 may include two or more X capacitor units.

For example, the EMI filter 140 may include two or more first common mode filters 142.

For example, the EMI filter 140 may include two or more Y capacitor units.

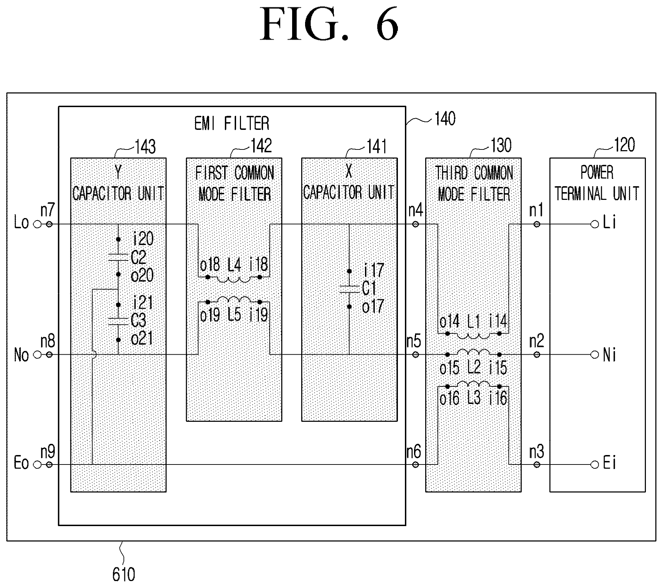

FIG. 6 is a diagram illustrating the power supply device 110 according to an embodiment.

Referring to Embodiment 610 in FIG. 6, the power supply device 110 may include at least one of the power terminal unit 120, the third common mode filter 130, or the EMI filter 140. The power supply device 110 in FIG. 6 may correspond to the power supply device 110 in FIG. 4 or FIG. 5. A redundant description is omitted.

The third common mode filter 130 may include at least one of a first inductor L1, a second inductor L2, or a third inductor L3.

The X capacitor unit 141 may include the first capacitor C1.

The first common mode filter 142 may include at least one of the fourth inductor L4 or the fifth inductor L5.

The Y capacitor unit 143 may include at least one of the second capacitor C2 or the third capacitor C3.

One end i14 of the first inductor L1 may be connected to the first terminal Li of the power terminal unit 120 through the node n1. The first terminal Li of the power terminal unit 120 may correspond to the first input terminal Li of the power supply device 110.

One end i15 of the second inductor L2 may be connected to the second terminal Ni of the power terminal unit 120 through the node n2. The second terminal Ni of the power terminal unit 120 may correspond to the second input terminal Ni of the power supply device 110.

One end i16 of the third inductor L3 may be connected to the third terminal Ei of the power terminal unit 120 through the node n3. The third terminal Ei of the power terminal unit 120 may correspond to the third input terminal Ei of the power supply device 110.

The other end o14 of the first inductor L1 may be connected to at least one of one end i17 of the first capacitor C1 or one end i18 of the fourth inductor L4 through the node n4.

For example, the other end o14 of the first inductor L1 may be commonly connected to one end i17 of the first capacitor C1 and one end i18 of the fourth inductor L4 through the node n4.

The other end o15 of the second inductor L2 may be connected to at least one of the other end o17 of the first capacitor C1 or one end i19 of the fifth inductor L5 through the node n5.

For example, the other end o15 of the second inductor L2 may be commonly connected to the other end o17 of the first capacitor C1 and one end i19 of the fifth inductor L5 through the node n5.

The other end o16 of the third inductor L3 may be connected to at least one of the other end o20 of the second capacitor C2, one end i21 of the third capacitor C3, or the third output terminal Eo of the power supply device 110 through the node n6. The node n6 may be correspond to the node n9.

For example, the other end o16 of the third inductor L3 may be commonly connected to the other end o20 of the second capacitor C2, one end i21 of the third capacitor C3, or the third output terminal Eo of the power supply device 110 through the node n6.

The other end o18 of the fourth inductor L4 may be connected to at least one of one end i20 of the second capacitor C2 or a first output terminal Lo of the power supply device 110 through the node n7.

For example, the other end o18 of the fourth inductor L4 may be commonly connected to one end i20 of the second capacitor C2 and the first output terminal Lo of the power supply device 110 through the node n7.

The other end o19 of the fifth inductor L5 may be connected to at least one of the other end o21 of the third capacitor C3 or the second output terminal No of the power supply device 110 through the node n8.

For example, the other end o19 of the fifth inductor L5 may be commonly connected to the other end o21 of the third capacitor C3 and the second output terminal No of the power supply device 110 through the node n8.

The first input terminal i1 of the third common mode filter 130 in FIG. 5 may be connected to one end i14 of the first inductor L1.

The second input terminal i2 of the third common mode filter 130 in FIG. 5 may be connected to one end i15 of the second inductor L2.

The third input terminal i3 of the third common mode filter 130 in FIG. 5 may be connected to one end i16 of the third inductor L3.

The first output terminal o1 of the third common mode filter 130 of FIG. 5 may be connected to the other end o14 of the first inductor L1.

The second output terminal o2 of the third common mode filter 130 in FIG. 5 may be connected to the other end o15 of the second inductor L2.

The third output terminal o3 of the third common mode filter 130 in FIG. 5 may be connected to the other end o16 of the third inductor L3.

The first input terminal i7 and first output terminal o7 of the X capacitor unit 141 in FIG. 5 may be connected to one end i17 of the first capacitor C1.

The second input terminal i8 and second output terminal o8 of the X capacitor unit 141 in FIG. 5 may be connected to the other end o17 of the first capacitor C1.

The first input terminal i9 of the first common mode filter 142 in FIG. 5 may be connected to one end i18 of the fourth inductor L4.

The second input terminal i10 of the first common mode filter 142 in FIG. 5 may be connected to one end i19 of the fifth inductor L5.

The first output terminal o9 of the first common mode filter 142 in FIG. 5 may be connected to the other end o18 of the fourth inductor L4.

The second output terminal o10 of the first common mode filter 142 in FIG. 5 may be connected to the other end o19 of the fifth inductor L5.

The first input terminal i11 and first output terminal o11 of the Y capacitor unit 143 in FIG. 5 may be connected to one end i20 of the second capacitor C2 through the node n7.

The second input terminal i12 and second output terminal o12 of the Y capacitor unit 143 in FIG. 5 may be connected to the other end o21 of the third capacitor C3 through the node n8.

The third input terminal i13 and third output terminal o13 of the Y capacitor unit 143 in FIG. 5 may be commonly connected to the other end o20 of the second capacitor C2 and one end i21 of the third capacitor C3 through the node n9.

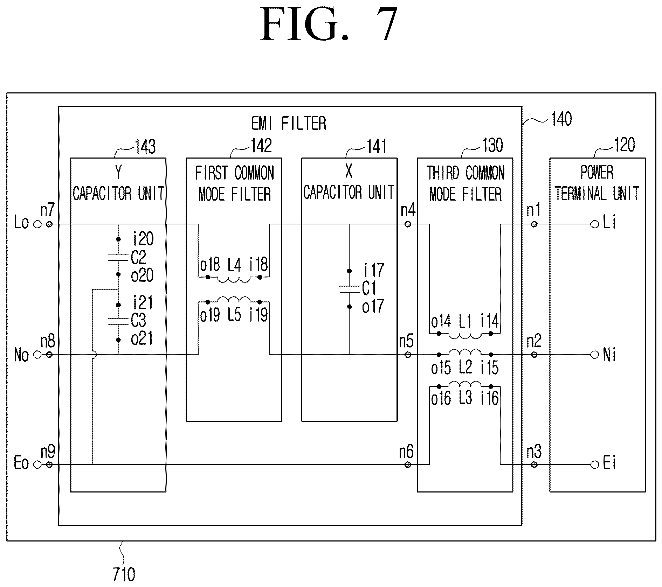

FIG. 7 is a diagram illustrating the power supply device 110 according to an embodiment.

In Embodiment 710 in FIG. 7, the power supply device 110 may include the power terminal unit 120 and the electro-magnetic interference (EMI) filter 140.

The EMI filter 140 may include at least one of the third common mode filter 130, the X capacitor unit 141, the first common mode filter 142, or the Y capacitor unit 143. Descriptions of the respective components may correspond to those provided with reference to FIGS. 4 to 6. Redundant descriptions thereof are omitted.

The descriptions provided with reference to FIGS. 4 to 6 describes that the third common mode filter 130 is disposed outside the EMI filter 140. According to an embodiment, the third common mode filter 130 may be disposed inside the EMI filter 140. That is, the third common mode filter 130 may be included in the EMI filter 140.

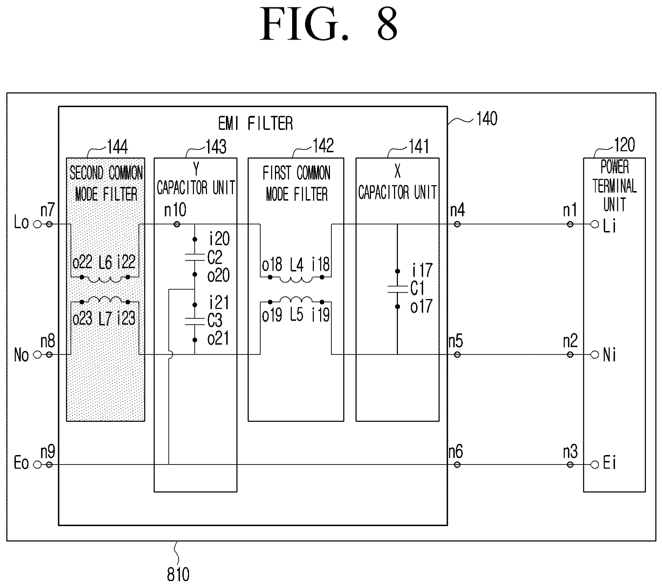

FIG. 8 is a diagram illustrating the power supply device 110 according to an embodiment.

Embodiment 810 in FIG. 8 may correspond to Embodiment 610 in FIG. 6. A redundant description thereof is omitted.

The EMI filter 140 may include at least one of the X capacitor unit 141, the first common mode filter 142, the Y capacitor unit 143, or the second common mode filter 144.

The second common mode filter 144 may include at least one of the sixth inductor L6 or the seventh inductor L7.

One end i22 of the sixth inductor L6 may be connected to at least one of one end i20 of the second capacitor C2 or the other end o18 of the fourth inductor L4 through a node n10.

For example, one end i22 of the sixth inductor L6 may be commonly connected to one end i20 of the second capacitor C2 and the other end o18 of the fourth inductor L4 through the node n10.

The other end o22 of the sixth inductor L6 may be connected to the first output terminal Lo of the power supply device 110 through the node n7.

One end i23 of the seventh inductor L7 may be connected to at least one of the other end o21 of the third capacitor C3 or the other end o19 of the fifth inductor L5 through a node n11.

For example, one end i23 of the seventh inductor L7 may be commonly connected to the other end o21 of the third capacitor C3 and the other end o19 of the fifth inductor L5 through the node n11.

The other end o23 of the seventh inductor L7 may be connected to the second output terminal No of the power supply device 110 through the node n8.

The other end o18 of the fourth inductor L4 may be connected to at least one of one end i20 of the second capacitor C2 or one end i22 of the sixth inductor L6 through the node n10.

For example, the other end o18 of the fourth inductor L4 may be commonly connected to one end i20 of the second capacitor C2 and one end i22 of the sixth inductor L6 through the node n10.

The other end o19 of the fifth inductor L5 may be connected to at least one of the other end o21 of the third capacitor C3 or one end i23 of the seventh inductor L7 through the node n11.

For example, the other end o19 of the fifth inductor L5 may be commonly connected to the other end o21 of the third capacitor C3 and one end i23 of the seventh inductor L7 through the node n11.

According to various embodiments, a first common mode filter 131 may be omitted. In Embodiment 810 in FIG. 8, the first common mode filter 131 is omitted.

The first input terminal i4 of the EMI filter 140 may be connected to the first input terminal Li of the power terminal unit through the node n4. The node n4 may correspond to the node n1.

The second input terminal i5 of the EMI filter 140 may be connected to the second input terminal Ni of the power terminal unit through the node n5. The node n5 may correspond to the node n2.

The third input terminal i6 of the EMI filter 140 may be connected to the third input terminal Ei of the power terminal unit through the node n6. The node n6 may correspond to the node n3.

FIG. 9 is a diagram illustrating the power supply device 110 according to an embodiment.

Embodiment 910 in FIG. 9 may correspond to Embodiment 810 in FIG. 8. A redundant description thereof is omitted.

The second common mode filter 144 may include at least one of the sixth inductor L6, the fourth capacitor C4, the seventh inductor L7, or the fifth capacitor C5.

One end i22 of the sixth inductor L6 may be connected to at least one of one end i24 of the fourth capacitor C4, one end i20 of the second capacitor C2, or the other end o18 of the fourth inductor L4 through the node n10.

For example, one end i22 of the sixth inductor L6 may be commonly connected to one end i24 of the fourth capacitor C4, one end i20 of the second capacitor C2, and the other end o18 of the fourth inductor L4 through the node n10.

The other end o22 of the sixth inductor L6 may be connected to at least one of the other end o24 of the fourth capacitor C4 or the first output terminal Lo of the power supply device 110 through the node n7.

For example, the other end o22 of the sixth inductor L6 may be connected to the other end o24 of the fourth capacitor C4 and the first output terminal Lo of the power supply device 110 through the node n7.

One end i23 of the seventh inductor L7 may be connected to at least one of one end i25 of the fifth capacitor C5, the other end o21 of the third capacitor C3, or the other end o19 of the fifth inductor L5 through the node n11.

For example, one end i23 of the seventh inductor L7 may be commonly connected to one end i25 of the fifth capacitor C5, the other end o21 of the third capacitor C3, and the other end o19 of the fifth inductor L5 through the node n11.

The other end o23 of the seventh inductor L7 may be connected to at least one of the other end o25 of the fifth capacitor C5 or the second output terminal No of the power supply device 110 through the node n8.

For example, the other end o23 of the seventh inductor L7 may be connected to the other end o25 of the fifth capacitor C5 or the second output terminal No of the power supply device 110 through the node n8.

The other end o18 of the fourth inductor L4 may be connected to at least one of one end i20 of the second capacitor C2, one end i22 of the sixth inductor L6, or one end i24 of the fourth capacitor C4 through the node n10.

For example, the other end o18 of the fourth inductor L4 may be commonly connected to one end i20 of the second capacitor C2, one end i22 of the sixth inductor L6, and one end i24 of the fourth capacitor C4 through the node n10.

The other end o19 of the fifth inductor L5 may be connected to at least one of the other end o21 of the third capacitor C3, one end i23 of the seventh inductor L7, or one end i25 of the fifth capacitor C5 through the node n11.

For example, the other end o19 of the fifth inductor L5 may be commonly connected to the other end o21 of the third capacitor C3, one end i23 of the seventh inductor L7, and one end i25 of the fifth capacitor C5 through the node n11.

The other end o20 of the second capacitor C2 may be connected to at least one of one end i21 of the third capacitor C3 or the third output terminal Eo through the node n9.

For example, the other end o20 of the second capacitor C2 may be commonly connected to one end i21 of the third capacitor C3 or the third output terminal Eo through the node n9.

The third output terminal Eo may be connected to the ground wire (or the ground terminal).

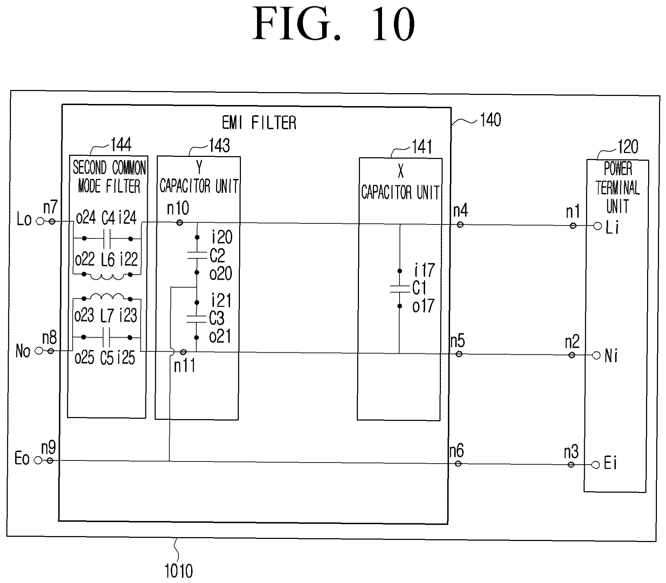

FIG. 10 is a diagram illustrating the power supply device 110 according to an embodiment.

Embodiment 1010 in FIG. 10 may correspond to Embodiment 910 in FIG. 9. A redundant description thereof is omitted. In Embodiment 910 in FIG. 9, the first common mode filter 142 may be omitted.

The node n10 may correspond to the node n4 and the node n1. The node n11 may correspond to the node n5 and the node n2.

The first input terminal Li of the power terminal unit 120 may be connected to at least one of one end i17 of the first capacitor C1, one end i20 of the second capacitor C2, one end i24 of the fourth capacitor C4, or one end i22 of the sixth inductor L6 through the node n1.

For example, the first input terminal Li of the power terminal unit 120 may be commonly connected to one end i17 of the first capacitor C1, one end i20 of the second capacitor C2, one end i24 of the fourth capacitor C4, and one end i22 of the sixth inductor L6 through the node n1.

The second input terminal Ni of the power terminal unit 120 may be connected to at least one of the other end o17 of the first capacitor C1, the other end o21 of the third capacitor C3, one end i25 of the fifth capacitor C5, or one end i23 of the seventh inductor L7 through the node n2.

For example, the second input terminal Ni of the power terminal unit 120 may be connected to the other end o17 of the first capacitor C1, the other end o21 of the third capacitor C3, one end i25 of the fifth capacitor C5, and one end i23 of the seventh inductor L7 through the node n2.

FIG. 11 is a diagram illustrating the power supply device 110 according to an embodiment.

Embodiment 1110 in FIG. 11 may correspond to Embodiment 910 in FIG. 9. A redundant description thereof is omitted.

The EMI filter 140 may include at least one of the first X capacitor unit 141, the first common mode filter 142, the Y capacitor unit 143, the second common mode filter 144, or the second X capacitor unit 145. The X capacitor unit 141 may be referred to as the first X capacitor unit 141.

The second X capacitor unit 145 may include the sixth capacitor C6.

One end i26 of the sixth capacitor C6 may include at least one of one end i24 of the fourth capacitor C4, one end i22 of the sixth inductor L6, one end i20 of the second capacitor C2, or the other end o18 of the fourth inductor L4 through the node n10.

For example, one end i26 of the sixth capacitor C6 may be commonly connected to one end i24 of the fourth capacitor C4, one end i22 of the sixth inductor L6, one end i20 of the second capacitor C2, and the other end o18 of the fourth inductor L4 through the node n10.

The other end o26 of the sixth capacitor C6 may be connected to at least one of one end i25 of the fifth capacitor C5, one end i23 of the seventh inductor L7, the other end o21 of the third capacitor C3, or the other end o19 of the fifth inductor L5 through the node n11.

For example, the other end o26 of the sixth capacitor C6 may be commonly connected to one end i25 of the fifth capacitor C5, one end i23 of the seventh inductor L7, the other end o21 of the third capacitor C3, and the other end o19 of the fifth inductor L5 through the node n11.

The other end o18 of the fourth inductor L4 may be connected to at least one of one end i20 of the second capacitor C2, one end i26 of the sixth capacitor C6, one end i22 of the sixth inductor L6, or one end i24 of the fourth capacitor C4 through the node n10.

For example, the other end o18 of the fourth inductor L4 may be commonly connected to one end i20 of the second capacitor C2, one end i26 of the sixth capacitor C6, one end i22 of the sixth inductor L6, and one end i24 of the fourth capacitor C4 through the node n10.

The other end o19 of the fifth inductor L5 may be connected to at least one of the other end o21 of the third capacitor C3, the other end o26 of the sixth capacitor C6, one end i23 of the seventh inductor L7, or one end i25 of the fifth capacitor C5 through the node n11.

For example, the other end o19 of the fifth inductor L5 may be commonly connected to the other end o21 of the third capacitor C3, the other end o26 of the sixth capacitor C6, one end i23 of the seventh inductor L7, and one end i25 of the fifth capacitor C5 through the node n11.

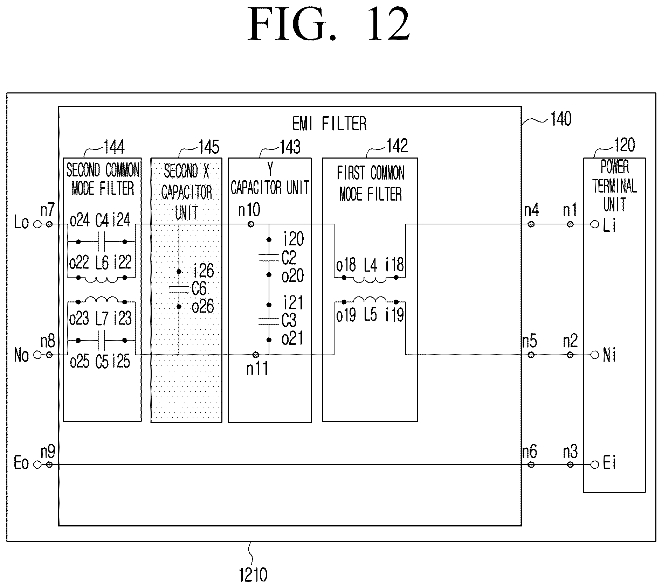

FIG. 12 is a diagram illustrating the power supply device 110 according to an embodiment.

Embodiment 1310 in FIG. 13 may correspond to Embodiment 1210 in FIG. 12. A redundant description thereof is omitted. In Embodiment 1210 of FIG. 12, the first X capacitor unit 141 may be omitted.

The EMI filter 140 may include at least one of the first common mode filter 142, the Y capacitor unit 143, the second common mode filter 144, or the second X capacitor unit 145.

One end i18 of the fourth inductor L4 may be connected to the first input terminal Li of the power terminal unit 120 through the node n4.

One end i19 of the fifth inductor L5 may be connected to the second input terminal Ni of the power terminal unit 120 through the node n5.

FIG. 13 is a diagram illustrating the power supply device 110 according to an embodiment.

Referring to Embodiment 1310 in FIG. 13, the EMI filter 140 may include at least one of the X capacitor unit 141, the first common mode filter 142, the Y capacitor unit 143, the second common mode filter 144, or the differential mode filter 146.

The differential mode filter 146 may remove the differential mode current, which is noise occurring in power. The differential mode filter 146 may include at least one of an eighth inductor L8 or a ninth inductor L9.

One end i27 of the eighth inductor L8 may be connected to at least one of the other end o24 of the fourth capacitor C4 or the other end o22 of the sixth inductor L6 through a node n12.

For example, one end i27 of the eighth inductor L8 may be commonly connected to the other end o24 of the fourth capacitor C4 and the other end o22 of the sixth inductor L6 through the node n12.

The other end o27 of the eighth inductor L8 may be connected to the first output terminal Lo through the node n7.

One end i28 of the ninth inductor L9 may be connected to at least one of the other end o25 of the fifth capacitor C5 or the other end o23 of the seventh inductor L7 through a node n13.

For example, one end i28 of the ninth inductor L9 may be commonly connected to the other end o25 of the fifth capacitor C5 and the other end o23 of the seventh inductor L7 through the node n13.

The other end o28 of the ninth inductor L9 may be connected to the second output terminal No through the node n8.

According to various embodiments, the second capacitor unit 145 in FIG. 12 may be further added to Embodiment 1310 in FIG. 13. A redundant description thereof is omitted.

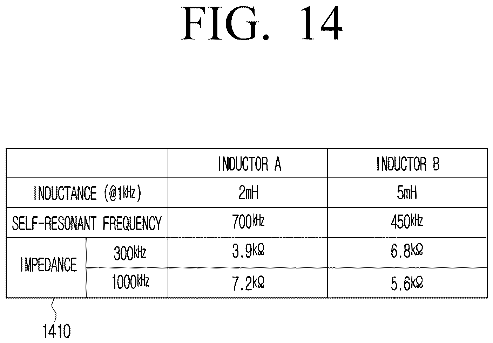

FIG. 14 is a diagram illustrating a change in impedance according to an inductor type.

A table 1410 in FIG. 14 may include physical property information of an inductor A and an inductor B.

Under a frequency of 1 kHz, inductance of the inductor A is assumed to be 2 mH. A self-resonant frequency of the inductor A may be 700 kHz. When the frequency is 300 kHz, impedance of the inductor A may be 3.9 kΩ. When the frequency is 1000 kHz, impedance of the inductor A may be 7.2 kΩ.

Under the frequency of 1 kHz, inductance of the inductor B is assumed to be 5 mH. A self-resonant frequency of the inductor B may be 450 kHz. When the frequency is 300 kHz, impedance of the inductor B may be 6.8 kΩ. When the frequency is 1000 kHz, impedance of the inductor B may be 5.6 kΩ.

When using an inductor having a relatively large, impedance at a specific frequency (e.g., 300 kHz) may be increased. When using an inductor having a relatively large inductance, a self-resonant frequency may decrease, and impedance at a specific frequency (e.g., 1000 kHz) may rather decrease.

Physical characteristics or the like may change depending on the inductance of an inductor used in the electronic apparatus 100. When an inductor having a larger inductance is used to increase impedance, overall physical characteristics of the electronic apparatus 100 may change.

FIG. 15 is a diagram illustrating an operation of determining a capacitance of an additionally disposed capacitor for impedance increase.

Equation 1500 in FIG. 15 may include a process of calculating a capacitance of the capacitor added to a target inductor.

Equation 1500 may include Cp={1/2}*{1/(w^2*L)-1/(Z_L*w)}.

Cp may represent a capacitance of the capacitor added to the inductor.

w may represent a frequency. The frequency (w) may be expressed as 2πf. f may represent a vibration frequency.

L may represent the target inductor.

Z_L may represent target impedance. The target impedance may represent total impedance of the second common mode filter 144 that the user intends to implement.

Embodiment 1510 may represent the second common mode filter 144 in FIG. 9. The second common mode filter 144 may include the sixth inductor L6 and the seventh inductor L7.

The sixth inductor L6 and the seventh inductor L7 included in the second common mode filter 144 may have a parasitic resistance and a parasitic capacitance, respectively. The parasitic resistance may represent an internal resistance generated when a current flows through a coil in the inductor. The parasitic capacitance may represent an internal capacitance generated due to an electrical connection (or contact) between the inductor and surrounding components.

R_L6 may represent a parasitic resistance of the sixth inductor L6.

C_L6 may represent a parasitic capacitance of the sixth inductor L6.

R_L7 may represent a parasitic resistance of the seventh inductor L7.

C_L7 may represent a parasitic capacitance of the seventh inductor L7.

Embodiment 1520 may represent the second common mode filter 144 in FIG. 11. The second common mode filter 144 may include the sixth inductor L6 and the seventh inductor L7. The second common mode filter 144 may further include target capacitors C4 and C5. The target capacitors may be additionally disposed in the respective inductors included in the second common mode filter 144.

The target capacitor may be determined based on a Cp value calculated using Equation 1500. The target capacitor, that is, the fourth capacitor C4, may be disposed in parallel with the sixth inductor L6. The target capacitor, that is, the fifth capacitor C5, may be disposed in parallel with the seventh inductor L7.

FIG. 16 is a diagram illustrating a change in impedance caused by the additionally disposed capacitor.

Referring to FIG. 16, a graph 1600 may represent a change in impedance according to various embodiments. Embodiment 1610 may correspond to Embodiment 1510 in FIG. 15, and Embodiment 1620 may correspond to Embodiment 1520 in FIG. 15.

**In** Embodiment 1510 in FIG. 15, the second common mode filter 144 is assumed to include only the sixth inductor L6 and the seventh inductor L7. Embodiment 1610 may represent a change in impedance according to a frequency (or vibration frequency) in Embodiment 1510 in FIG. 15.

In Embodiment 1520 of FIG. 15, the second common mode filter 144 is assumed to include all the sixth inductor L6, the target capacitor C4 of the sixth inductor L6, the seventh inductor L7, and the target capacitor C5 of the seventh inductor L7. Embodiment 1620 may represent a change in impedance according to a frequency (or vibration frequency) in Embodiment 1520 in FIG. 15.

When a target capacitor is added, an impedance characteristic of the second common mode filter 144 may change. When the target capacitor is added, a resonant frequency of the second common mode filter 144 may decrease. When the target capacitor is added, impedance in a specific frequency band (e.g., 10^5 Hz to 10^6Hz) may increase.

Impedance of the second common mode filter 144 may be changed by adding a target capacitor without changing inductance.

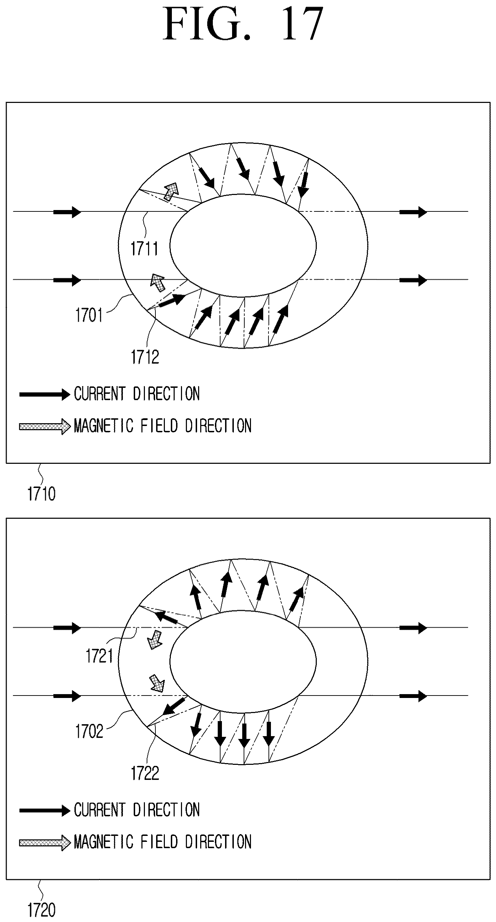

FIG. 17 is a diagram illustrating the first common mode filter 142.

The first common mode filter 142 may represent a two-terminal common mode choke. The first common mode filter 142 may include a core and two windings. The core may be a circular core. The core may be made of a magnetic material. The two windings may be wound in the same direction.

Referring to Embodiment 1710 in FIG. 17, the first common mode filter 142 may include a core 1701, a first winding 1711, and a second winding 1712. The first winding 1711 and the second winding 1712 may be wound in the same direction.

Being wound in the same direction may indicate that both the windings 1711 and 1712 are wound from outside to inside along the same first surface of the core 1701.

Based on a direction in which the common current moves along a circular central axis of the core 1701, the first winding 1711 and the second winding 1712 may be wound on the core 1701 in different directions. The first winding 1711 may be wound on the core 1701 in a clockwise direction, and the second winding 1712 may be wound on the core 1701 in a counter-clockwise direction.

Referring to Embodiment 1720 in FIG. 17, the first common mode filter 142 may include a core 1702, a first winding 1721, and a second winding 1722. The first winding 1721 and the second winding 1722 may be wound in the same direction.

Being wound in the same direction may indicate that both the windings 1721 and 1722 are wound from outside to inside along the same first surface of the core 1702.

Based on a direction in which the common current moves along a circular central axis of the core 1702, the first winding 1721 and the second winding 1722 may be wound on the core 1702 in different directions. The first winding 1721 may be wound in the counter-clockwise direction, and the second winding 1722 may be wound in the clockwise direction.

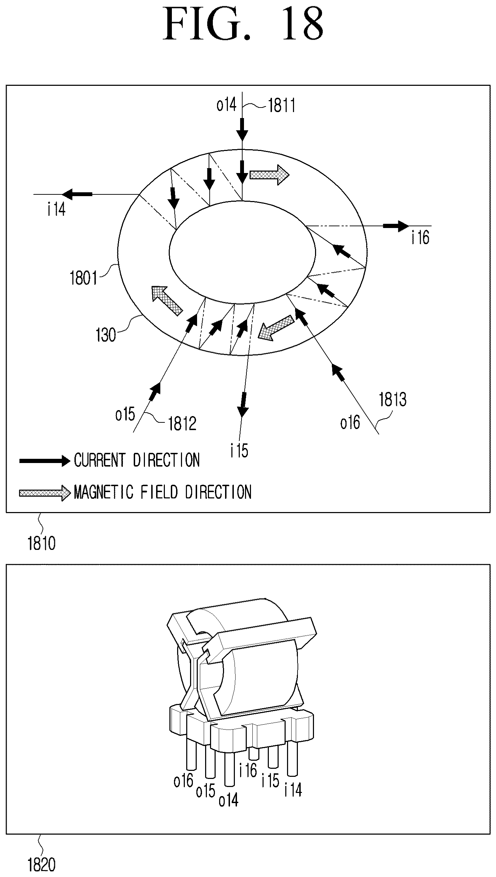

FIG. 18 is a diagram illustrating the third common mode filter 130.

The third common mode filter 130 may be a three-terminal common mode choke. Three terminals may refer to terminals having three input or output ports. The third common mode filter 130 may include three pairs of input/output terminals.

Referring to Embodiment 1810, the third common mode filter 130 may include a core 1801, a first winding 1811, a second winding 1812, and a third winding 1813. The first winding 1811, the second winding 1812, and the third winding 1813 may be wound in the same direction.

Being wound in the same direction may indicate that all the three windings 1811, 1812, and 1813 are wound from outside to inside along the same first surface of the core 1801.

Based on a direction in which the common current moves along a circular central axis of the core 1801, the first winding 1811, the second winding 1812, and the third winding 1813 may be wound in the same direction. The first winding 1811, the second winding 1812, and the third winding 1813 may be wound in the counter-clockwise direction.

Embodiment 1820 in FIG. 18 is a side view of the third common mode filter 130.

The third common mode filter 130 may be designed to satisfy a dielectric strength condition between the first winding 1811 and the second winding 1812, connected to the first input terminal Li and second input terminal N9 of the power terminal unit 120, and the third winding 1813 connected to the third input terminal Ei.

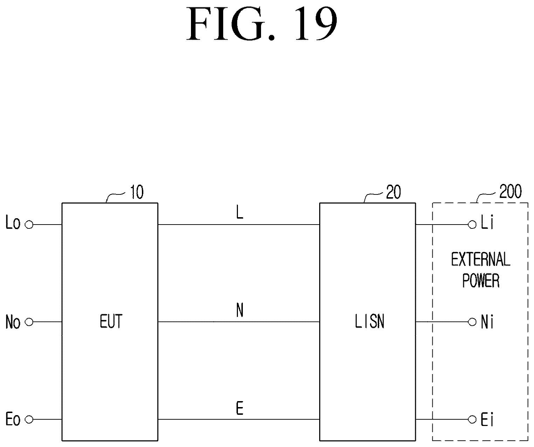

FIG. 19 is a diagram illustrating an equipment under test (EUT) and a line impedance stabilization network (LISN).

Referring to FIG. 19, an equipment under test (EUT) 10 may be connected to a line impedance stabilization network (LISN) 20. The line impedance stabilization network 20 may be connected to external power 200. The external power 200 may include three terminals Li, Ni, and Ei. The equipment under test 10 may correspond to the electronic apparatus 100.

The equipment under test 10 may represent a noise source. The equipment under test 10 may be referred to as a noise source device.

The line impedance stabilization network 20 may be referred to as a power line impedance stabilization network. The line impedance stabilization network 20 may be a standard instrument for testing electromagnetic interference. The line impedance stabilization network 20 may provide accurate (or stable) line impedance and may prevent circuit damage caused by overload by providing high impedance.

The line impedance stabilization network 20 may be a measuring instrument for measuring electro magnetic interference (EMI) or electro magnetic compatibility (EMC). The line impedance stabilization network 20 may separate only noise by using a filter function.

One end of the line impedance stabilization network 20 may be connected to the equipment under test 10, and the other end of the line impedance stabilization network 20 may be connected to the external power 200.

According to an embodiment, the electronic apparatus 100 may separate noise by adding the line impedance stabilization network 20 thereto. The electronic apparatus 100 may analyze noise based on the separated noise.

The electronic apparatus 100 may control the third common mode filter 130 based on an analysis result. For example, the electronic apparatus 100 may measure a noise level based on the analysis result and may perform a mode in which a switch S1 in FIG. 10 operates in an ON state based on measured noise.

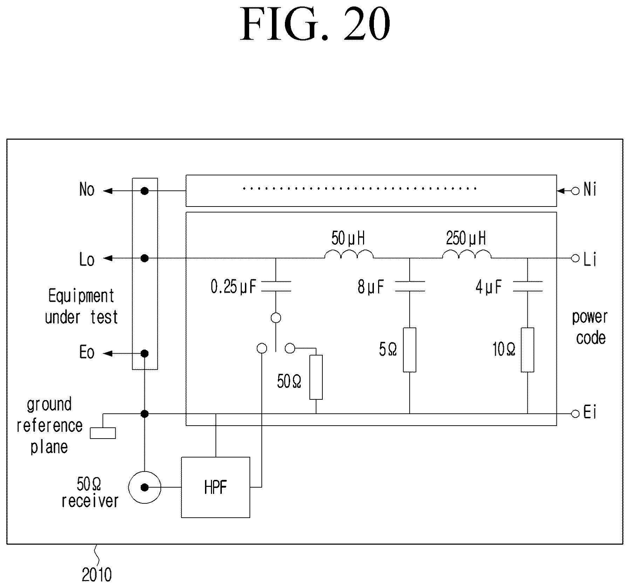

FIG. 20 is a diagram illustrating the line impedance stabilization network 20.

Referring to Embodiment 2010 in FIG. 20, the line impedance stabilization network 20 may be a circuit network for measuring conducted emission (CE) in a band ranging from 9 kHz or 150 kHz to 30 MHz.

The line impedance stabilization network 20 may include at least one capacitor, at least one inductor, or at least one resistor. The line impedance stabilization network 20 may include a high-pass filter (HPF).

Embodiment 2010 of FIG. 20 illustrates one circuit among various circuits included in the line impedance stabilization network 20. The line impedance stabilization network 20 may be implemented as another circuit different from the embodiment 2010.

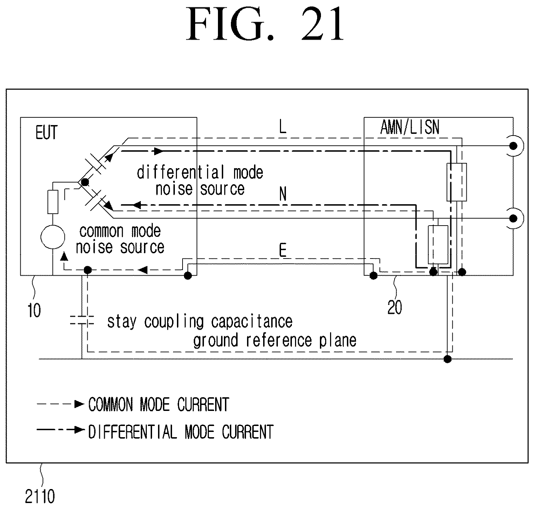

FIG. 21 is a diagram illustrating an interference current flowing between the equipment under test 10 and the line impedance stabilization network 20.

Referring to Embodiment 2110 in FIG. 21, the line impedance stabilization network 20 may be connected to the equipment under test 10. The equipment under test 10 may correspond to the electronic apparatus 100.

Noise may occur when power is supplied to the equipment under test 10 and the line impedance stabilization network 20. For example, at least one of the common mode current or the differential mode current may occur.

The equipment under test 10 and the line impedance stabilization network 20 may be connected to each other through a line L, a line N, or a line E. The line E may be a virtual line implemented as a ground. In actuality, the line E may not include a separate wire.

The common mode current may flow through the line L, the line **N,** or the line E. The common mode current may flow from the equipment under test 10 toward the line impedance stabilization network 20 through the line L.

The common mode current may flow from the equipment under test 10 toward the line impedance stabilization network 20 through the line N.

The common mode current may flow from the line impedance stabilization network 20 toward the equipment under test 10 through the line E.

The differential mode current may flow through the line L or the line N. The differential mode current may flow from the equipment under test 10 toward the line impedance stabilization network 20 through the line L.

The differential mode current may flow from the line impedance stabilization network 20 toward the equipment under test 10 through the line N.

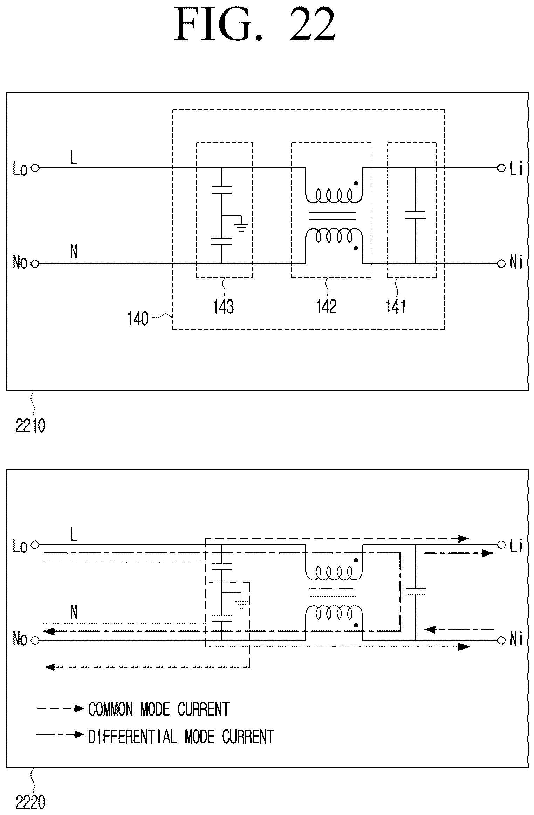

FIG. 22 is a diagram illustrating the EMI filter and the interference current according to an embodiment.

Embodiment 2210 in FIG. 22 illustrates the EMI filter 140. The EMI filter 140 may include at least one of the X capacitor unit 141, the first common mode filter 142, or the Y capacitor unit 143.

The X capacitor unit 141 may return (by-pass) the differential mode current into the product interior.

The first common mode filter 142 may block the flow of interference current to prevent emission to the outside, thereby suppressing noise emission.

The Y capacitor unit 143 may return (by-pass) the common mode current into the product interior.

Embodiment 2220 of FIG. 22 illustrates noise flowing when power is supplied to the EMI filter 140 in Embodiment 2210. The EMI filter 140 in Embodiment 2210 may remove noise (i.e., the common mode current or the differential mode current). The EMI filter 140 may remove the common mode current by using the first common mode filter 142.

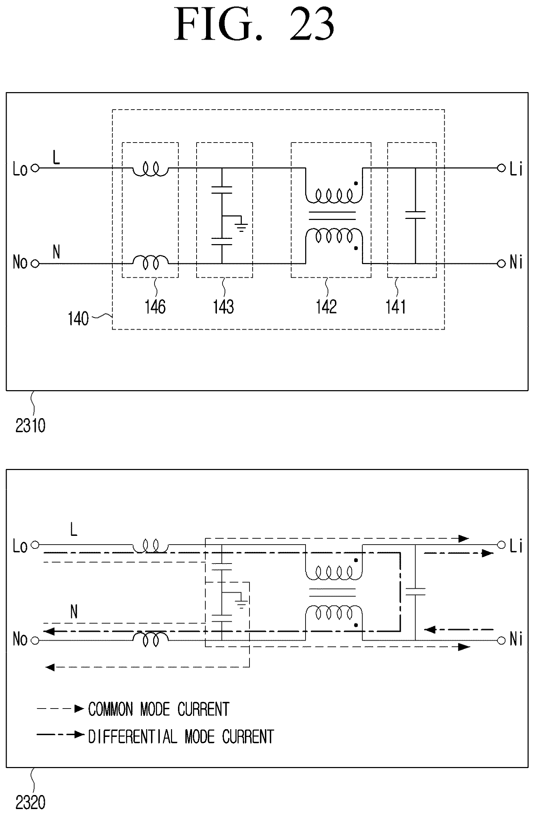

FIG. 23 is a diagram illustrating the EMI filter and the interference current according to an embodiment.

Referring to Embodiment 2310 in FIG. 23, the EMI filter 140 may include at least one of the X capacitor unit 141, the first common mode filter 142, the Y capacitor unit 143, or the differential mode filter 146. Although not illustrated in FIG. 23, the EMI filter 140 may further include the second common mode filter 144.

Embodiment 2320 in FIG. 23 illustrates flows of the common mode current and the differential mode current in the EMI filter 140 in Embodiment 2310.

The EMI filter 140 may remove the common mode current by using the first common mode filter 142. The EMI filter 140 may remove the differential mode current by using the differential mode filter 146. The differential mode filter 146 may include two inductors. According to an implementation example, the differential mode filter 146 may include one inductor. The one inductor may be disposed on the line L or the line N.

Meanwhile, the methods according to the various embodiments of the present disclosure described above may be implemented in the form of an application capable of being installed on a conventional electronic apparatus.

**In** addition, the methods according to the various embodiments of the present disclosure described above may be implemented only by software upgrade or hardware upgrade of the conventional electronic apparatus.

The various embodiments of the present disclosure described above may also be performed through an embedded server included in the electronic apparatus, or through an external server of at least one of the electronic apparatus or a display device.

Meanwhile, according to an embodiment of the present disclosure, the various embodiments described above may be implemented by software including an instruction stored on a machine-readable storage medium readable by a machine (e.g., a computer). The machine may be a device that invokes the stored instruction from a storage medium, may be operated based on the invoked instruction, and may include the electronic apparatus according to the disclosed embodiments. If the instruction is executed by the processor, the processor may directly perform, or perform functions corresponding to the instructions by using other components under control of the processor. The instruction may include codes generated or executed by a compiler or an interpreter. The machine-readable storage medium may be provided in the form of a non-transitory storage medium. Here, the term "non-transitory" merely indicates that the storage medium is tangible without including a signal, and does not distinguish whether data are semi-permanently or temporarily stored in the storage medium.

In addition, according to an embodiment of the present disclosure, the method according to the various embodiments described above may be provided as a computer program product. The computer program product may be traded as a product between a seller and a buyer. The computer program product may be distributed in the form of a machine-readable storage medium (e.g., a compact disc read only memory (CD-ROM)) or online through an application store (e.g., Play Store^{™}). In the case of online distribution, at least part of the computer program product may be temporarily stored or generated in a storage medium such as a memory of a manufacturer server, an application store server, or a relay server.

Each of the components (e.g., modules or programs) according to the various embodiments described above may include a single entity or a plurality of entities, and some of the corresponding sub-components described above may be omitted or other sub-components may be further included in the various embodiments. Alternatively or additionally, some of the components (e.g., the modules or the programs) may be integrated into one entity, and may perform functions performed by the respective corresponding components before integration in the same or similar manner. Operations performed by the modules, the programs or other components according to the various embodiments may be executed in a sequential manner, a parallel manner, an iterative manner or a heuristic manner, at least some of the operations may be performed in a different order or be omitted, or other operations may be added.

Although the preferred embodiments according to the present disclosure are illustrated and referred to as above, the present disclosure is not limited to the above-described specific embodiments, and may be variously modified by those skilled in the art to which the present disclosure pertains without departing from the scope of the present disclosure as claimed in the accompanying claims. These modifications should also be understood to fall within the spirit of the present disclosure.

## Claims

1. A dryer comprising:
a drum configured to accommodate an object to be dried;
a hot air supply device configured to supply hot air into the drum;
a motor configured to rotate the drum;
a power supply device configured to supply power to the motor; and
at least one processor configured to control the motor,
wherein the power supply device includes:
a power terminal unit configured to receive alternating current (AC) power including a ground wire through a first input terminal and a second input terminal;
an electro-magnetic interference (EMI) filter configured to remove noise included in the AC power; and
a ground terminal including the ground wire connected to the power supply device, and
the EMI filter includes:
an X capacitor unit including a first capacitor;
a first common mode filter including a first core, a first inductor wound around the first core, and a second inductor wound around the first core;
a Y capacitor unit including a second capacitor and a third capacitor connected in series; and
a second common mode filter including a second core, a third inductor wound around the second core, a fourth capacitor connected in parallel to the third inductor, a fourth inductor wound around the second core, and a fifth capacitor connected in parallel to the fourth inductor.

2. The dryer as claimed in claim 1, wherein the at least one processor is configured to control the hot air supply device by supplying, to the motor, the AC power from which noise is removed through the electro-magnetic interference (EMI) filter.

3. The dryer as claimed in claim 1, wherein the power supply device includes a first output terminal and a second output terminal connected to the second common mode filter.

4. The dryer as claimed in claim 3, wherein one end of the first inductor is commonly connected to one end of the first capacitor and the first input terminal, and
the other end of the first inductor is commonly connected to one end of the second capacitor, one end of the fourth capacitor, and one end of the third inductor.

5. The dryer as claimed in claim 4, wherein one end of the second inductor is commonly connected to the other end of the first capacitor and the second input terminal, and
the other end of the second inductor is commonly connected to the other end of the third capacitor, one end of the fifth capacitor, and one end of the fourth inductor.

6. The dryer as claimed in claim 5, wherein the other end of the third inductor is connected to the other end of the fourth capacitor and the first output terminal, and
the other end of the fourth inductor is connected to the other end of the fifth capacitor and the second output terminal.

7. The dryer as claimed in claim 1, wherein the first inductor and the second inductor are connected in series, and
the third inductor and the fourth inductor are connected in series.

8. The dryer as claimed in claim 1, wherein the first core is made of a magnetic material,
the first inductor and the second inductor are wound around the first core in the same direction,
the second core is made of a magnetic material, and
the third inductor and the fourth inductor are wound around the second core in the same direction.

9. The dryer as claimed in claim 1, wherein the ground terminal is commonly connected to the other end of the second capacitor and one end of the third capacitor.

10. The dryer as claimed in claim 1, wherein the motor is a brushless direct current (BLDC) motor, and
the motor receives power passing through the EMI filter.

11. The dryer as claimed in claim 1, further comprising a board on which the power terminal unit and the EMI filter are disposed.

12. The dryer as claimed in claim 1, wherein the X capacitor unit is a first X capacitor unit,
the EMI filter further includes a second X capacitor unit including a sixth capacitor, and
the second X capacitor unit is connected in parallel to the first X capacitor unit, the first common mode filter, the Y capacitor unit, and the second common mode filter.

13. The dryer as claimed in claim 12, wherein one end of the sixth capacitor is commonly connected to the other end of the first inductor, one end of the second capacitor, one end of the fourth capacitor, and one end of the third inductor, and
the other end of the sixth capacitor is commonly connected to the other end of the second inductor, the other end of the third capacitor, one end of the fifth capacitor, and one end of the fourth inductor.

14. The dryer as claimed in claim 1, wherein the EMI filter includes a differential mode filter including a fifth inductor and a sixth inductor,
the differential mode filter is connected in parallel to the first X capacitor unit, the first common mode filter, the Y capacitor unit, and the second common mode filter,
one end of the fifth inductor is commonly connected to the other end of the fourth capacitor and the other end of the third inductor,
the other end of the fifth inductor is connected to the first output terminal,
one end of the sixth inductor is commonly connected to the other end of the fifth capacitor and the other end of the fourth inductor, and
the other end of the sixth inductor is connected to the second output terminal.

15. A home appliance comprising:
a motor;
a power supply device configured to supply power to the motor; and
at least one processor configured to control the motor,
wherein the power supply device includes:
a power terminal unit configured to receive alternating current (AC) power including a ground wire through a first input terminal and a second input terminal;
an electro-magnetic interference (EMI) filter configured to remove noise included in the AC power; and
a ground terminal including the ground wire connected to the power supply device, and
the EMI filter includes:
an X capacitor unit including a first capacitor;
a first common mode filter including a first core, a first inductor wound around the first core, and a second inductor wound around the first core;
a Y capacitor unit including a second capacitor and a third capacitor connected in series; and
a second common mode filter including a second core, a third inductor wound around the second core, a fourth capacitor connected in parallel to the third inductor, a fourth inductor wound around the second core, and a fifth capacitor connected in parallel to the fourth inductor.
